# EUROPÄISCHE PATENTSCHRIFT

(11) **EP 3 143 417 B1**
(45) Veröffentlichungstag und Bekanntmachung des Hinweises auf die Patenterteilung: **27.04.2022**
(21) Anmeldenummer: 15723214.1
(22) Anmeldetag: 13.05.2015
(51) Int. Cl.: G01R 31/327, H02B 13/065, H01H 33/02

(54) **VERFAHREN UND SYSTEM ZUM PRÜFEN EINER SCHALTANLAGE FÜR ENERGIEÜBERTRAGUNGSANLAGEN**
METHOD AND SYSTEM FOR TESTING A SWITCHING INSTALLATION FOR POWER TRANSMISSION INSTALLATIONS
PROCÉDÉ ET SYSTÈME PERMETTANT DE VÉRIFIER UNE INSTALLATION DE DISTRIBUTION DESTINÉE À UNE INSTALLATION DE TRANSMISSION D'ÉNERGIE

(30) Priorität: 16.05.2014 AT 503472014
(43) Veröffentlichungstag der Anmeldung: 22.03.2017
(73) Patentinhaber: Omicron electronics GmbH, 6833 Klaus (AT)
(72) Erfinder: KLAPPER, Ulrich, A-6830 Rankweil (AT); RENAUDIN, Thomas, 78440 Sailly (FR)
(74) Vertreter: Banzer, Hans-Jörg
(86) Internationale Anmeldenummer: PCT/EP2015/060654
(87) Internationale Veröffentlichungsnummer: WO 2015/173330

(56) Entgegenhaltungen:
- EP-A1- 1 793 235
- CH-A5- 668 669
- DE-A1- 2 055 477
- DE-A1- 19 648 643
- DE-U1-202007 018 709

## Beschreibung

Die vorliegende Erfindung betrifft ein Verfahren und ein System, um eine Schaltanlage für Energieübertragungsanlagen oder Energieübertragungsnetze zu prüfen.

Die Druckschrift DE 196 48 643 A1 offenbart eine metallgekapselte gasisolierte Schaltanlage. Dabei wird zur Kontrollmessung ein konstanter Gleichstrom über eine Eingangsklemme in einen Messkreis eingespeist. Der Messkreis führt von der Eingangsklemme über einen ersten Schnellerder, ein Aktivteil, einen Leistungsschalter und einen zweiten Schnellerder zu einer Abgangsklemme. Dabei wird der Spannungsabfall zwischen der Eingangsklemme und der Abgangsklemme gemessen.

Die Druckschrift DE 20 55 477 A1 beschreibt die Überwachung von Hochspannungsleitern. Dazu wird ein Gleichstrom über eine Metallkapselung und Erdungsleiter geleitet. Wenn ein Trennschalter und Erdungstrenner geschlossen sind, ergibt sich ein zum Strompfad durch den Erdungsleiter paralleler Strompfad, der durch den Hochspannungsleiter verläuft.

Die Druckschrift DE 20 2007 018709 U1 beschreibt einen Leistungsschalter, welcher einen Stromsensor zur Erfassung eines Primärstroms umfasst.

Die Druckschrift EP 1 793 235 A1 offenbart ein Überwachungssystem für Hochspannungsschalter, wobei eine Rogowskispule als Stromsensor eingesetzt wird.

Die Druckschrift CH 668 669 A5 beschreibt ein Ermitteln des Abbrandes der Kontaktstücke eines in einer gekapselten Schaltanlage eingebauten Schaltgeräts.

In elektrischen gasisolierten Schaltanlagen, wie sie insbesondere für Energieübertragungsanlagen eingesetzt werden, kommen elektrische Schalter, insbesondere Lastschalter oder Leistungsschalter, zum Einsatz. Dabei wird unter einem Lastschalter oder einem Leistungsschalter ein spezieller Schalter verstanden, welcher für hohe Ströme (> 1 kA) ausgelegt ist. Ein Leistungsschalter kann nicht nur Betriebsströme und geringe Überlastströme schalten, sondern auch bei Fehlern hohe Überlastströme und Kurzschlussströme (bis 800 kA) sicher ausschalten. Lastschalter oder Leistungsschalter können einpolig oder dreipolig aufgebaut sein. Bei Tests dieser Schaltanlagen, insbesondere der Schalter dieser Schaltanlagen, welche in regelmäßigen Abständen durchgeführt werden müssen, werden unterschiedliche Tests oder Messungen, wie beispielsweise eine Schaltzeitenmessung oder eine Widerstandsmessung durchgeführt.

Da bei einer gasisolierten Schaltanlage die eigentlichen Leiter oder Anschlüsse meist nicht zugänglich sind, wird nach dem Stand der Technik die elektrische Verbindung zu dem zu überprüfenden Schalter über so genannte Erdungstrenner hergestellt. Ein Erdungstrenner verbindet üblicherweise den Leiter oder den Anschluss des Schalters beim Prüfen mit Masse bzw. Erde, beispielsweise der geerdeten Außenwand der Schaltanlage, um gefährliche Ströme bzw. Spannungen abzuleiten. Eine nach dem Stand der Technik notwendige Manipulation der Erdungstrenner zur Prüfung der Schaltanlage ist allerdings aus sicherheitstechnischen Gründen nachteilig.

Daher stellt sich die vorliegende Erfindung die Aufgabe, eine Prüfung einer Schaltanlage für Energieübertragungsanlagen ohne eine Manipulation der Erdungstrenner bereitzustellen.

Erfindungsgemäß wird diese Aufgabe durch ein Verfahren zum Prüfen einer Schaltanlage für Energieübertragungsanlagen nach Anspruch 1, durch ein System zum Prüfen einer Schaltanlage für Energieübertragungsanlagen nach Anspruch 9 und durch eine Schaltanlage für Energieübertragungsanlagen nach Anspruch 13 gelöst. Die abhängigen Ansprüche definieren bevorzugte und vorteilhafte Ausführungsformen der vorliegenden Erfindung.

Im Rahmen der vorliegenden Erfindung wird ein Verfahren zum Prüfen einer Schaltanlage (insbesondere einer gasisolierten Schaltanlage) für Energieübertragungsanlagen oder Energieübertragungsnetze bereitgestellt. Dabei umfasst die Schaltanlage einen Schalter (insbesondere einen Lastschalter oder Leistungsschalter), welcher eine erste Seite bzw. einen ersten Anschluss des Schalters mit einer zweiten Seite bzw. mit einem zweiten Anschluss des Schalters je nach Schalterstellung entweder verbindet oder trennt, und zwei Erdungstrenner. Dabei ist jeder der beiden Erdungstrenner ausgestaltet, um einen der beiden Anschlüsse (eine der beiden Seiten) je nach Zustand des Erdungstrenners entweder mit Erde bzw. Masse zu verbinden oder von Masse bzw. Erde zu trennen. Das erfindungsgemäße Verfahren umfasst folgende Schritte:
- Erzeugen eines Stroms durch den Schalter.
- Bestimmen einer Größe des Stroms durch den Schalter.

Dabei sind die beiden Erdungstrenner während der Prüfung, d.h. während der Schritte des Erzeugens und des Bestimmens, ständig geschlossen und nicht geöffnet.

Da das erfindungsgemäße Prüfverfahren weder zum Erzeugen des Stroms durch den Schalter noch zur Bestimmung der Größe des Stroms durch den Schalter auch nur einen der beiden Erdungstrenner verändern, d.h. öffnen, muss, wird vorteilhafterweise eine Manipulation der beiden Erdungstrenner zum Prüfen der Schaltanlage vermieden. Daher kann die erfindungsgemäße Prüfung der Schaltanlage vorteilhafterweise sicherer durchgeführt werden, als dies nach dem Stand der Technik möglich ist.

Das erfindungsgemäße Prüfverfahren kann dabei eine Schaltzeitenmessung, d.h. ein Messen von Schaltzeiten des Schalters, und/oder eine Bestimmung des elektrischen Widerstands des geschlossenen Schalters, was auch als Mikroohmmessung bekannt ist, umfassen. Bei der Schaltzeitenmessung werden dem Schalter über elektrische Signale Befehle zum Aus- und Einschalten zugeführt. Anschließend werden diejenigen Zeitintervalle, welche der Schalter zum Öffnen oder Schließen ausgehend vom Zeitpunkt der Aussendung des jeweiligen elektrischen Signals benötigt, anhand der bestimmten Größe des Stroms durch den Schalter gemessen. Abhängig von diesen Zeitintervallen kann dann beurteilt werden, ob sich der Schalter oder die Schaltanlage in einem ausreichend guten Zustand befindet, oder ob die Schaltanlage Wartung benötigt oder sogar defekt ist. Mit anderen Worten kann durch die erfindungsgemäße Prüfung das Zeitverhalten des Schalters beim Öffnen und Schließen besonders sicher und einfach überprüft werden. Die Bestimmung des elektrischen Widerstands kann mit Hilfe einer Messung der über dem Schalter anliegenden Spannung in Form einer Vierdrahtmessung erfolgen, bei welcher die Anschlüsse des Spannungsmessers direkt mit den Erdungstrennern verbunden werden.

Zur Bestimmung der Größe des Stroms durch den Schalter existieren zwei Möglichkeiten.
- Bei der ersten Möglichkeit wird ein Strom erzeugt, welcher von dem ersten Anschluss des Schalters zu dem zweiten Anschluss des Schalters fließt. Da beide Erdungstrenner geschlossen sind, teilt sich dieser Strom bei geschlossenem Schalter in einen Strom durch den Schalter und in einen Strom über die Erdverbindung auf. Indem der über Masse bzw. Erde der Schaltanlage abfließende Strom gemessen wird, kann bei Kenntnis des Gesamtstroms die Größe des Stroms durch den Schalter quasi indirekt bestimmt werden, indem insbesondere die Differenz aus dem Gesamtstrom und dem über Masse abfließenden Strom bestimmt wird.

Anders ausgedrückt umfasst das Erzeugen des Stroms durch den

Schalter gemäß der ersten Möglichkeit beispielsweise ein Anschließen einer Vorrichtung zum Erzeugen des Stroms durch den Schalter an einem Verzweigungspunkt, an welchem ein Ende eines der Erdungstrenner und die Masse der Schaltanlage verbunden ist. Das Bestimmen der Größe des Stroms kann dann ein Messen eines weiteren Stroms umfassen, welcher zwischen dem Verzweigungspunkt und der Masse fließt. Bei Kenntnis des Gesamtstroms kann dann die Größe des Stroms durch den Schalter anhand des gemessenen weiteren Stroms bestimmt werden.
- Bei der zweiten Möglichkeit wird der durch den Schalter fließende Strom direkt gemessen, so dass keine Berechnung notwendig ist, um die Größe des durch den Schalter fließenden Stroms zu bestimmen.

Auch bei der zweiten Möglichkeit kann das Erzeugen des Stroms durch den Schalter ein Anschließen der Vorrichtung zum Erzeugen des Stroms durch den Schalter an dem Verzweigungspunkt umfassen, an welchem ein Ende eines der Erdungstrenner und die Masse der Schaltanlage verbunden ist. Auch das Bestimmen der Größe des Stroms durch den Schalter kann ein Messen eines weiteren Stroms umfassen, welcher bei der zweiten Möglichkeit allerdings zwischen dem Verzweigungspunkt und dem Ende des Erdungstrenners und damit (bei geschlossenem Schalter) über den Schalter fließt. Damit entspricht dieser weitere Strom dem Strom durch den Schalter (wenn dieser geschlossen ist), so dass die gemessene Größe des weiteren Stroms der Größe des Stroms durch den Schalter entspricht.

Bei beiden Möglichkeiten kann der Strom durch den Schalter zu jedem Zeitpunkt bestimmt werden.

Der Strom durch den Schalter kann entweder mit Hilfe einer Stromquelle oder mit Hilfe einer Spannungsquelle erzeugt werden.

Wenn der Strom durch den Schalter mit Hilfe einer Spannungsquelle erzeugt wird, wird die Spannungsquelle insbesondere parallel zu dem Schalter angeschlossen.

Der Strom durch den Schalter kann dabei als Gleichstrom, als Wechselstrom oder als ein Gemisch, welches sowohl einen Gleichstrom als auch einen Wechselstrom umfasst, erzeugt werden. Darüber hinaus kann der Strom durch den Schalter auch transient, d.h. rasch (z. B. sprunghaft) ansteigend und/oder abfallend sein.

Vorteilhafterweise kann zum Messen des (weiteren) Stroms ein Stromwandler mit einem geteilten Kern ("split core") eingesetzt werden, welcher um die entsprechende Leitung, in welcher der Strom zu messen ist, herum angebracht wird. Dadurch kann vorteilhafterweise der Stromwandler nachträglich in der Schaltanlage angeschlossen werden, ohne dass dazu beispielsweise die Erdungstrenner manipuliert werden müssen. Dabei wird unter einem Stromwandler eine Art Messwandler verstanden, welcher wie eine Art Transformator aufgebaut ist bzw. arbeitet.

Darüber hinaus kann vorteilhafterweise ein Klappferrit angebracht werden, um die Induktivität eines Strompfads zur Erde bzw. Masse der Schaltanlage zu erhöhen, wodurch dann ein größerer Anteil des erzeugten Stroms durch den (geschlossenen) Schalter fließt. Das Klappferrit oder ferromagnetische Material kann dabei um eine Verbindung von einem Erdungstrenner nach Masse oder um beide Verbindungen vom jeweiligen Erdungstrenner nach Masse herum angeordnet werden.

Ähnlich wie bei dem geteilten Kern des Stromwandlers handelt es sich bei dem Klappferrit um einen geteilten Ferritkern, welcher nachträglich um eine Leitung innerhalb der Schaltanlage herum angebracht werden kann. Der Effekt des ferromagnetischen Materials nimmt dabei mit zunehmender Frequenz des erzeugten Stroms zu, so dass ein umso größerer Anteil des erzeugten Stroms durch den (geschlossenen) Schalter gezwungen wird, je höher die Frequenz des erzeugten Wechselstroms ist.

Falls es sich bei dem erzeugten Strom durch den Schalter um einen Gleichstrom handelt, kann zum Bestimmen der Größe des Stroms durch den Schalter eine Messvorrichtung, welche mit dem Neel-Effekt arbeitet, eingesetzt werden. Dabei wird der zu messende Gleichstrom anhand einer von dem Gleichstrom induzierten Spannung gemessen, wobei dann abhängig von der gemessenen Spannung die Größe des Stroms durch den Schalter bestimmt wird.

Zur Erzielung des Neel-Effekts wird ein superparamagnetisches Material in einer Spule angeordnet. Aufgrund der Nicht-Linearität des superparamagnetischen Materials umfasst die über der Spule abfallende Spannung mehrere Frequenzkomponenten. Anhand einer Frequenzverschiebung dieser Frequenzkomponenten kann dann auch die Größe eines Gleichstroms erfasst werden. Das Messen eines Gleichstroms kann auch mit Hilfe einer Hallsonde erfolgen.

Da bei dieser Ausführungsform mit Hilfe des Neel-Effekts der Strom durch den Schalter direkt bestimmt oder gemessen werden kann, kann vorteilhafterweise auch der elektrische Widerstand des geschlossenen Schalters berechnet bzw. bestimmt werden, wenn zusätzlich die über dem Schalter abfallende Gleichspannung bekannt ist oder gemessen wird.

Anhand der Bestimmung der Größe des Stroms durch den (geschlossenen) Schalter können auch Zeitpunkte einer abrupten Änderung im Stromfluss durch den Schalter erfasst werden, um abhängig davon diejenigen Zeitpunkte zu bestimmen, zu welchen der Schalter eingeschaltet und/oder ausgeschaltet wird.

Durch die Ermittlung der entsprechenden Schaltzeitpunkte des Schalters, d.h. durch die Ermittlung der Zeitpunkte, zu welchen der Schalter eingeschaltet und/oder ausgeschaltet wird, kann vorteilhafterweise die vorab erwähnte Schalterzeitmessung realisiert werden.

Gemäß einer bevorzugten erfindungsgemäßen Ausführungsform umfasst die Schaltanlage mehrere Schalter, wobei jeder dieser Schalter wahlweise zwei Anschlüsse des jeweiligen Schalters verbindet oder trennt. Eine solche Schaltanlage ist zum Schalten eines mehrphasigen (z.B. dreiphasigen) Stroms ausgestaltet. Dabei ist jedem Anschluss eines Schalters jeweils ein Erdungstrenner zugeordnet, über welchen der jeweilige Anschluss in der Regel beim Prüfen mit Erde bzw. Masse verbunden wird und beim normalen Betrieb der Schaltanlage von Erde getrennt werden kann. Die Größe des Stroms durch den jeweiligen Schalter kann entweder direkt gemessen werden oder anhand einer Messung von in die Erde der Schaltanlage abfließenden Strömen bei Kenntnis des Gesamtstroms, welcher sich aus der Summe der Ströme durch die Schalter und der in die Erde abfließenden Ströme zusammensetzt, bestimmt werden.

Diese Ausführungsform ermöglicht unter anderem die Bestimmung der jeweiligen Zeitpunkte, zu welchen der jeweilige Schalter geöffnet und/oder geschlossen wird, und die Bestimmung des elektrischen Widerstands des jeweiligen geschlossenen Schalters. Dabei können die Ströme gleichzeitig oder nacheinander und zu jedem Zeitpunkt gemessen oder ermittelt werden

Im Rahmen der vorliegenden Erfindung wird auch ein System zum Prüfen einer Schaltanlage für Energieübertragungsanlagen bereitgestellt. Wie bei dem erfindungsgemäßen Verfahren umfasst die Schaltanlage einen Schalter, welcher eine erste Seite des Schalters mit einer zweiten Seite des Schalters wahlweise verbindet oder trennt, und zwei Erdungstrenner. Das System umfasst eine erste Vorrichtung, um einen Strom zu erzeugen, und eine zweite Vorrichtung, um eine Messgröße (z.B. einen Strom oder eine Spannung) der Schaltanlage zu messen, und Steuermittel. Das System ist ausgestaltet, um bei ständig geschlossenen Erdungstrennern mit Hilfe der ersten Vorrichtung einen Strom durch den Schalter zu erzeugen und um mit Hilfe der Steuermittel ausgehend von der Messgröße, welche mit Hilfe der zweiten Vorrichtung erfasst wurde, eine Größe des Stroms durch den Schalter zu bestimmen, ohne dass dabei einer der beiden Erdungstrenner geöffnet wird.

Die Vorteile des erfindungsgemäßen Systems entsprechen im Wesentlichen den Vorteilen des erfindungsgemäßen Verfahrens, welche vorab im Detail ausgeführt sind, so dass hier auf eine Wiederholung verzichtet wird.

Gemäß einer bevorzugten erfindungsgemäßen Ausführungsform umfasst die zweite Vorrichtung einen Strommesser mit einer Rogowskispule.

Prinzipiell ist eine Rogowskispule nur zur Messung von Wechselströmen konzipiert. Allerdings können mit Hilfe der Rogowskispule auch Veränderungen in Stromflüssen erfasst werden, wie sie beispielsweise beim Öffnen und/oder Schließen des Schalters auftreten. Über der Rogowskispule fällt eine Spannung ab, welche im Wesentlichen der ersten Ableitung eines durch die Rogowskispule fließenden Stroms entspricht.

Daher ist das erfindungsgemäße System insbesondere ausgestaltet, um Stromspitzen, welche beim Einschalten oder Ausschalten des Schalters bei dem durch den Schalter fließenden Strom auftreten, mit der Rogowskispule zu erfassen.

Mit Hilfe der Rogowskispule werden somit Spannungsspitzen erzeugt, anhand welcher relativ genau der Zeitpunkt des Öffnens und/oder Schließens des Schalters ermittelt werden kann, wodurch die vorab bereits erwähnte Schalterzeitmessung realisiert werden kann. Dabei entstehen beim Schließen des Schalters die Spannungsspitzen in einer bestimmten Richtung (d.h. mit einer bestimmten Polarität) und beim Öffnen des Schalters in der entgegengesetzten Richtung (d.h. mit entgegengesetzter Polarität), was ausgenutzt werden kann, um zu entscheiden, zu welchem Zeitpunkt der Schalter eingeschaltet oder ausgeschaltet wird.

Schließlich wird im Rahmen der vorliegenden Erfindung eine Schaltanlage für Energieübertragungsanlagen oder Energieübertragungsnetze bereitgestellt. Dabei umfasst die erfindungsgemäße Schaltanlage mindestens einen Schalter, welcher eine erste Seite des Schalters mit einer zweiten Seite des Schalters wahlweise verbindet oder trennt, und mindestens zwei der vorab erwähnten Erdungstrenner. Darüber hinaus umfasst die Schaltanlage ein vorab beschriebenes erfindungsgemäßes System.

Die vorliegende Erfindung ist insbesondere zum Testen von Schaltanlagen für Energieübertragungsanlagen einsetzbar. Selbstverständlich ist die vorliegende Erfindung nicht auf diesen bevorzugten Anwendungsbereich eingeschränkt, da die vorliegende Erfindung beispielsweise auch bei sonstigen Schaltanlagen eingesetzt werden kann, welche außerhalb einer Energieübertragungsanlage eingesetzt werden.

Im Folgenden wird die vorliegende Erfindung anhand von erfindungsgemäßen Ausführungsformen mit Bezug zu den Figuren im Detail beschrieben.

In Fig. 1 ist schematisch eine gasisolierte Schaltanlage dargestellt.

In Fig. 2 ist schematisch das erfindungsgemäße Prüfen einer gasisolierten Schaltanlage mit Stromerzeugungsvorrichtung und Strommesser dargestellt.

In Fig. 3 ist schematisch eine erfindungsgemäße Schaltanlage dargestellt, welche ein erfindungsgemäßes System umfasst.

In Fig. 4 ist schematisch das erfindungsgemäße Prüfen einer dreiphasigen Schaltanlage gemäß einer ersten Ausführungsform dargestellt.

In Fig. 5 ist schematisch das erfindungsgemäße Prüfen einer dreiphasigen Schaltanlage gemäß einer zweiten Ausführungsform dargestellt.

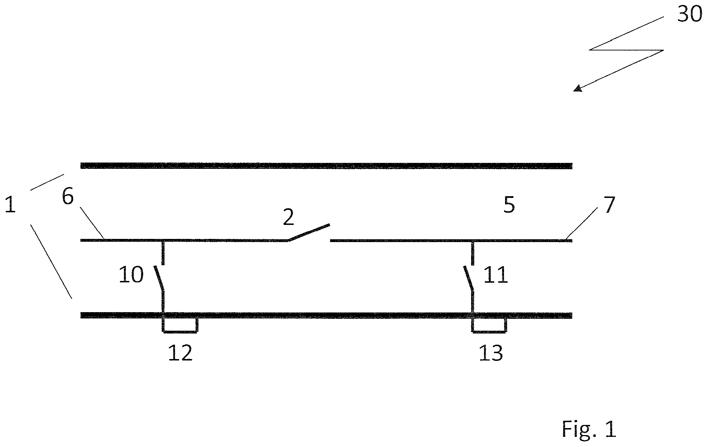

In Fig. 1 ist schematisch eine gasisolierte Schaltanlage 30 dargestellt, welche ein Gasrohr 1 umfasst, in welchem ein Lastschalter oder Leistungsschalter 2 der Schaltanlage 30 angeordnet ist. Das Gasrohr 1 ist vorzugsweise mit SF6 Gas 5, welches unter einem großen Druck steht, gefüllt, um auch bei relativ kleinen Abmessungen eine hohe Isolationsfähigkeit zu erreichen. Jeweils ein Erdungstrenner 10, 11 der Schaltanlage 30 ist mit einem Anschluss 6, 7 des Schalters 2 verbunden, um den jeweiligen Anschluss 6, 7 beim Prüfen der Schaltanlage 30 zu erden. Dazu sind die Erdungstrenner 10, 11 häufig mit Hilfe einer Schraubverbindung 12, 13 lösbar mit dem Gasrohr 1 der Schaltanlage 30 und damit mit Erde bzw. Masse verbunden.

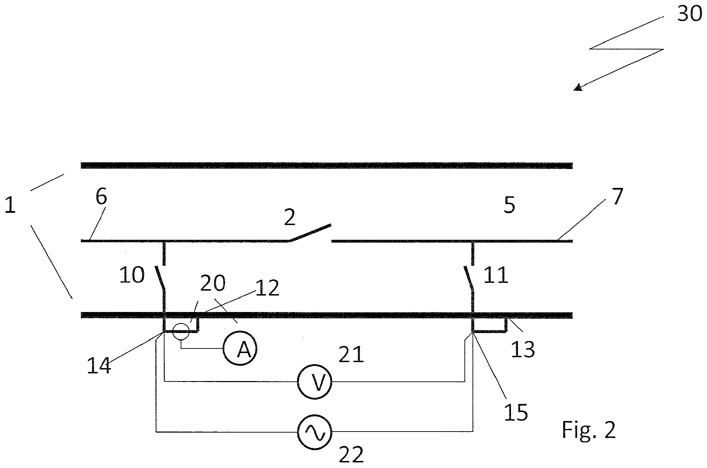

In Fig. 2 ist schematisch dargestellt, wie eine erfindungsgemäße Prüfung der in Fig. 1 dargestellten Schaltanlage 30 realisiert wird.

Dazu wird mit Hilfe einer Stromquelle 22 ein Signal oder ein Strom an einem Verzweigungspunkt 14 eingespeist. Bei geschlossenen Erdungstrennern 10, 11 und bei geschlossenem Schalter 2 fließt der von der Stromquelle 22 eingespeiste Strom teilweise vom Verzweigungspunkt 14 über den Erdungstrenner 10 und den Schalter 2 und den Erdungstrenner 11 zum zweiten Verzweigungspunkt 15, und teilweise fließt der Strom vom Verzweigungspunkt 14 über den Strommesser 20 zur Masse 1 und von dort ebenfalls zum zweiten Verzweigungspunkt 15. Wenn der von der Stromquelle 22 erzeugte Gesamtstrom bekannt ist, kann der durch den Schalter 2 fließende Strom anhand des von dem Strommesser 20 gemessenen Stroms durch die Bildung der Differenz aus dem Gesamtstrom abzüglich des gemessenen Stroms bestimmt werden.

Darüber hinaus kann optional mit Hilfe eines Spannungsmessers 21 mittels einer Vierdrahtmessung (d.h. der Spannungsmesser 21 ist direkt mit den Verzweigungspunkten 14, 15 verbunden) die zwischen den Verzweigungspunkten 14, 15 erzeugte Spannung gemessen werden. Bei Kenntnis sowohl des Stroms durch den Schalter 2 als auch der über dem Schalter 2 abfallenden Spannung kann der elektrische Widerstand des Schalters einschließlich der beiden Erdungstrenner bestimmt werden.

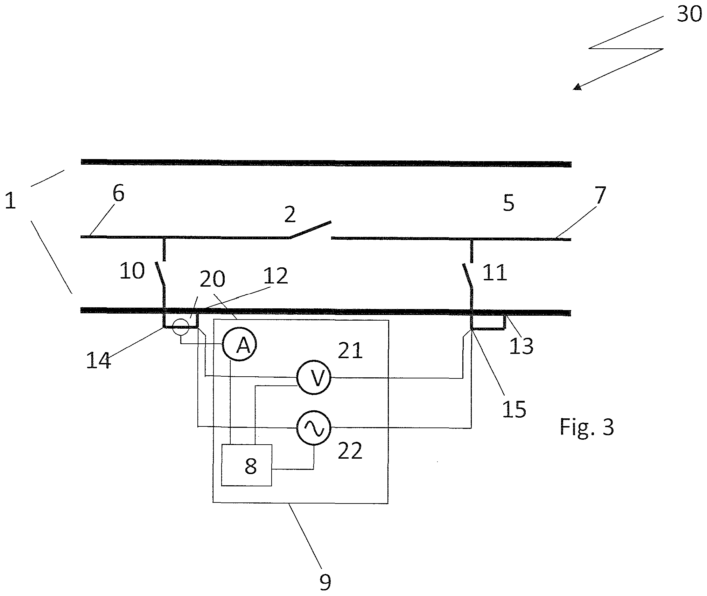

In Fig. 3 ist eine weitere erfindungsgemäße Ausführungsform zum Prüfen der in Fig. 1 dargestellten Schaltanlage 30 dargestellt.

Im Gegensatz zu der in Fig. 2 dargestellten Ausführungsform wird bei der in Fig. 3 dargestellten Ausführungsform derjenige Strom gemessen, welcher von dem Verzweigungspunkt 14 über den Erdungstrenner 10 zum Schalter 2 fließt. Mit anderen Worten wird bei der in Fig. 3 dargestellten Ausführungsform der Strom durch den (geschlossenen) Schalter 2 direkt gemessen, während er bei der in Fig. 2 dargestellten Ausführungsform indirekt gemessen und dann durch eine Berechnung abhängig von dem Gesamtstrom berechnet bzw. bestimmt wird.

Darüber hinaus ist in Fig. 3 schematisch ein erfindungsgemäßes System 9 zum Prüfen der Schaltanlage 30 dargestellt. Das erfindungsgemäße System 9 umfasst neben der Stromquelle 22 und dem Strommesser 20 eine Steuerung 8, um das Prüfen der Schaltanlage 30 zu koordinieren bzw. zu steuern.

Wie bei der in Fig. 2 dargestellten Ausführungsform kann optional bei der in Fig. 3 dargestellten Ausführungsform mit Hilfe des Spannungsmessers 21 insbesondere mittels einer Vierdrahtmessung die zwischen den Verzweigungspunkten 14, 15 erzeugte Spannung gemessen werden, wodurch wiederum der elektrische Widerstand des Schalters 2 bestimmt werden kann.

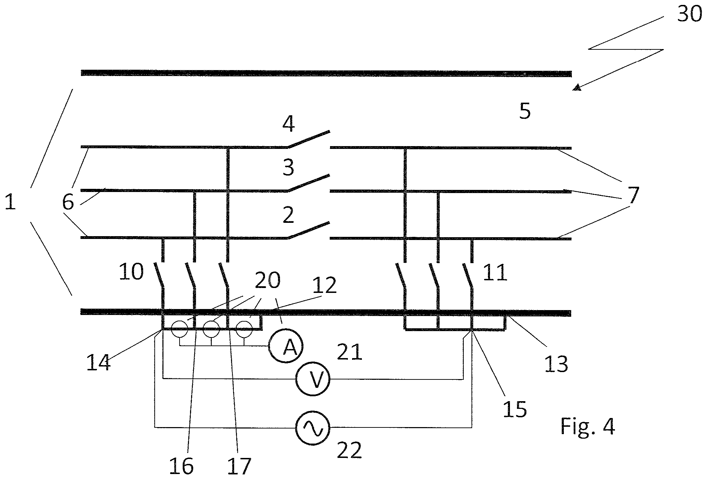

In Fig. 4 ist eine Schaltanlage 30 dargestellt, mit welcher ein dreiphasiger Strom geschaltet werden kann. Daher umfasst die in Fig. 4 dargestellte Schaltanlage 30 anstelle von nur einem Schalter 2 drei Schalter 2, 3, 4. Der Anschluss 6, 7 jedes Schalters 2, 3, 4 ist über einen eigenen Erdungstrenner 10, 11 wahlweise mit Masse 1 verbunden, so dass für jeden Schalter 2, 3, 4 jeweils zwei Erdungstrenner 10, 11 und somit insgesamt sechs Erdungstrenner 10, 11 für die in Fig. 4 dargestellte Schaltanlage 30 existieren.

Mit Hilfe mindestens einer Stromquelle 22 wird am Verzweigungspunkt 14 ein Strom eingeprägt, welcher entweder über eine der drei Reihenschaltungen, welche jeweils aus einem Erdungstrenner 10, gefolgt von einem Schalter 2, 3, 4 und einem weiteren Erdungstrenner 11 bestehen, zum Verzweigungspunkt 15 fließt oder über die drei Strommesser 20 nach Masse 1 abfließt. Indem der Strom, welcher vom Verzweigungspunkt 14 zum Verzweigungspunkt 16 fließt, der Strom, welcher vom Verzweigungspunkt 16 zum Verzweigungspunkt 17 fließt und der Strom, welcher vom Verzweigungspunkt 17 nach Masse abfließt mit Hilfe der Strommesser 20 gemessen werden, kann bei Kenntnis des von der Stromquelle 22 erzeugten Gesamtstroms auch der jeweilige Strom berechnet werden, welcher durch den jeweils (geschlossenen) Schalter 2, 3 oder 4 fließt.

Wiederum kann optional mit dem Spannungsmesser 21 insbesondere mittels einer Vierdrahtmessung die zwischen den Verzweigungspunkten 14, 15 erzeugte Spannung gemessen werden.

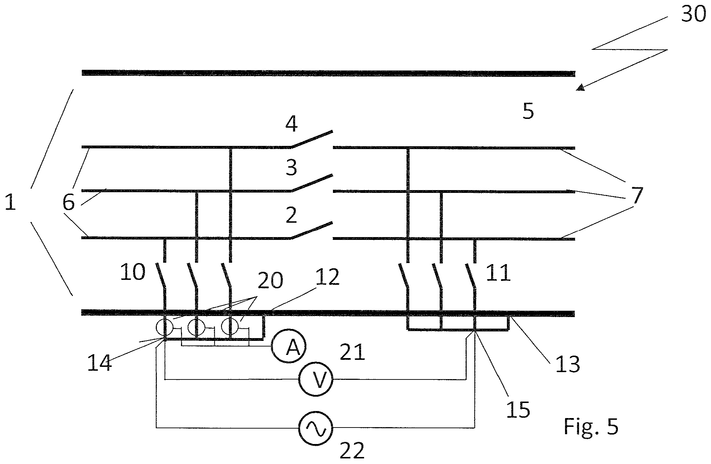

Die weitere in Fig. 5 dargestellte erfindungsgemäße Ausführungsform unterscheidet sich in ähnlicher Weise von der in Fig. 4 dargestellten Ausführungsform, wie sich die in Fig. 3 dargestellte Ausführungsform von der in Fig. 2 dargestellten Ausführungsform unterscheidet. Bei der in Fig. 5 dargestellten Ausführungsform werden anhand der Strommesser 20 die Ströme, welche jeweils durch den (geschlossenen) Schalter 2, 3 oder 4 fließen, direkt gemessen. Die anderen Merkmale der in Fig. 5 dargestellten Ausführungsform entsprechen der in Fig. 4 dargestellten Ausführungsform.

Die in den Figuren 2-5 dargestellten Strommesser 20 können insbesondere mit Hilfe von Stromwandlern, welche einen geteilten Kern umfassen, oder Néel-Effekt-Sensoren oder Rogowskispulen realisiert werden. Ein Strommesser 20 wird an der in den Figuren 2-5 gezeigten Stelle um den jeweiligen Leitungsabschnitt herum angeordnet, um jeweils den durch den Leitungsabschnitt fließenden Strom zu erfassen. Dadurch kann der Strom durch den Leitungsabschnitt fließende Strom vorteilhafterweise gemessen werden, ohne dass dazu in irgendeiner Weise einer der Erdungstrenner 10, 11 oder die Schraubverbindung 12, 13 manipuliert (z. B. gelöst) werden muss, wie dies nach dem Stand der Technik häufig der Fall ist.

### BEZUGSZEICHENLISTE

- 1: Gasrohr
- 2: Schalter
- 3: Schalter
- 4: Schalter
- 5: Gas
- 6, 7: Anschluss
- 8: Steuerung
- 9: System
- 10, 11: Erdungstrenner
- 12, 13: Schraubverbindung
- 14-17: Verzweigungspunkt
- 20: Messvorrichtung
- 21: Spannungsmesser
- 22: Stromquelle
- 30: Schaltanlage

## Patentansprüche

1. Verfahren zum Prüfen einer Schaltanlage (30) für Energieübertragungsanlagen,
wobei die Schaltanlage (30) einen Schalter (2), welcher eine erste Seite (6) des Schalters (2) mit einer zweiten Seite (7) des Schalters (2) wahlweise verbindet oder trennt, und zwei Erdungstrenner (10, 11) umfasst,
wobei jeder der beiden Erdungstrenner (10, 11) vorgesehen ist, um die erste Seite (6) oder die zweite Seite (7) wahlweise mit Erde (1) zu verbinden oder von Erde (1) zu trennen,
wobei das Verfahren umfasst:
- Erzeugen eines Stroms durch den Schalter (2), und
- Bestimmen einer Größe des Stroms durch den Schalter (2),
wobei die beiden Erdungstrenner (10, 11) während der Schritte des Erzeugens und des Bestimmens geschlossen sind,
wobei bei geschlossenen Erdungstrennern (10, 11) und bei geschlossenem Schalter (2) der erzeugte Strom teilweise über die Erdungstrenner (10, 11) und den Schalter und teilweise über Masse fließt, und
wobei entweder das Bestimmen der Größe des Stroms durch den Schalter (2) ein Messen eines in die Erde (1) der Schaltanlage (30) abfließenden Stroms und ein Bestimmen eines Gesamtstroms, welcher sich aus dem Strom durch den Schalter (2) und aus dem in die Masse (1) abfließenden Strom zusammensetzt, umfasst, oder der Strom durch den Schalter (2) direkt gemessen wird, um die Größe des Stroms durch den Schalter (2) zu bestimmen.

2. Verfahren nach Anspruch 1,
**dadurch gekennzeichnet,**
**dass** das Bestimmen der Größe des Stroms durch den Schalter (2) ein Anbringen eines geteilten Kerns eines Stromwandlers umfasst, um mittels des Stromwandlers einen weiteren Strom zu messen und um abhängig von dem gemessenen weiteren Strom die Größe des Stroms durch den Schalter (2) zu bestimmen, oder
**dass** das Bestimmen der Größe des Stroms durch den Schalter (2) mit Hilfe einer Rogowskispule erfolgt.

3. Verfahren nach einem der vorhergehenden Ansprüche,
**dadurch gekennzeichnet,**
**dass** das Verfahren ein Anbringen eines Klappferrits umfasst, um die Induktivität eines Strompfads zu der Erde (1) der Schaltanlage (30) zu erhöhen, um dadurch einen größeren Anteil des erzeugten Stroms durch den Schalter (2) zu zwingen.

4. Verfahren nach einem der vorhergehenden Ansprüche,
**dadurch gekennzeichnet,**
**dass** der Strom durch den Schalter (2) ein Gleichstrom ist,
**dass** das Bestimmen der Größe des Stroms durch den Schalter (2) ein Anordnen einer Messvorrichtung, welche mit dem Neel-Effekt arbeitet, umfasst, um einen weiteren Strom zu messen und davon abhängig den Strom durch den Schalter (2) zu bestimmen.

5. Verfahren nach einem der vorhergehenden Ansprüche,
**dadurch gekennzeichnet,**
**dass** eine über dem Schalter (2) abfallende Spannung bestimmt wird, und dass abhängig von der Größe des Stroms und der über dem Schalter (2) abfallenden Spannung ein Widerstand des Schalters (2) bestimmt wird.

6. Verfahren nach einem der vorhergehenden Ansprüche,
**dadurch gekennzeichnet,**
**dass** das Bestimmen der Größe des Stroms durch den Schalter (2) ein Erfassen von Zeitpunkten einer abrupten Änderung der Größe des Stroms umfasst, um daraus Schaltzeitpunkte des Schalters (2) abzuleiten.

7. Verfahren nach einem der vorhergehenden Ansprüche,
**dadurch gekennzeichnet,**
**dass** die Schaltanlage (30) mehrere Schalter (2-4) umfasst, welche wahlweise jeweils eine erste Seite (6) des jeweiligen Schalters (2-4) mit einer zweiten Seite (7) des jeweiligen Schalters (2-4) verbinden oder trennen, und zum Schalten eines mehrphasigen Stroms ausgestaltet sind,
**dass** jeder Seite (6; 7) jeweils ein Erdungstrenner (10; 11) zugeordnet ist, um die jeweilige Seite (6; 7) wahlweise mit Erde (1) zu verbinden oder von Erde (1) zu trennen, und
**dass** eine Größe eines Stroms durch jeden Schalter (2-4) direkt gemessen wird oder dass die Größe des Stroms durch jeden Schalter (2-4) durch ein Messen von in die Erde (1) der Schaltanlage (30) abfließende Ströme und ein Bestimmen eines Gesamtstroms, welcher sich aus den Strömen durch die Schalter (2-4) und aus den in die Erde (1) abfließenden Strömen zusammensetzt, bestimmt wird.

8. Verfahren nach einem der vorhergehenden Ansprüche,
**dadurch gekennzeichnet,**
**dass** die Schaltanlage eine gasisolierte Schaltanlage (30) ist.

9. System zum Prüfen einer Schaltanlage (30) für Energieübertragungsanlagen,
wobei die Schaltanlage (30) einen Schalter (2), welcher eine erste Seite (6) des Schalters (2) mit einer zweiten Seite (7) des Schalters (2) wahlweise verbindet oder trennt, und zwei Erdungstrenner (10, 11) umfasst,
wobei jeder der beiden Erdungstrenner (10, 11) vorgesehen ist, um die erste Seite (6) oder die zweite Seite (7) wahlweise mit Erde (1) zu verbinden oder von Erde (1) zu trennen,
wobei das System (9) eine erste Vorrichtung (22) zum Erzeugen eines Stroms, eine zweite Vorrichtung (20) zum Messen einer Messgröße der Schaltanlage (30) und Steuermittel (8) umfasst,
wobei das System (9) ausgestaltet ist, um bei geschlossenen Erdungstrennern (10, 11) mittels der ersten Vorrichtung (22) einen Strom durch den Schalter (2) zu erzeugen und um mittels der Steuermittel (8) anhand der mittels der zweiten Vorrichtung (20) gemessenen Messgröße eine Größe des Stroms durch den Schalter (2) zu bestimmen, ohne dass dazu einer der beiden Erdungstrenner (10, 11) geöffnet wird,
wobei das System (9) derart ausgestaltet ist, dass bei geschlossenen Erdungstrennern (10, 11) und bei geschlossenem Schalter (2) der erzeugte Strom teilweise über die Erdungstrenner (10, 11) und den Schalter und teilweise über Masse fließt, und
wobei das System (9) ausgestaltet ist, um entweder die Größe des Stroms durch den Schalter (2) zu bestimmen, indem ein in die Erde (1) der Schaltanlage (30) abfließender Strom gemessen wird und ein Gesamtstrom, welcher sich aus dem Strom durch den Schalter (2) und aus dem in die Masse (1) abfließenden Strom zusammensetzt, bestimmt wird, oder den Strom durch den Schalter (2) direkt zu messen, um die Größe des Stroms durch den Schalter (2) zu bestimmen.

10. System nach Anspruch 9,
**dadurch gekennzeichnet,**
**dass** die zweite Vorrichtung (20) einen Strommesser mit einer Rogowskispule umfasst.

11. System nach Anspruch 10,
**dadurch gekennzeichnet,**
**dass** das System (9) ausgestaltet ist, um Stromspitzen, welche beim Einschalten oder Ausschalten des Schalters (2) auftreten, mit der Rogowskispule zu erfassen.

12. System nach einem der Ansprüche 9-11,
**dadurch gekennzeichnet,**
**dass** das System (9) zur Durchführung des Verfahrens nach einem der Ansprüche 1-8 ausgestaltet ist.

13. Schaltanlage für Energieübertragungsanlagen,
wobei die Schaltanlage (30) einen Schalter (2), welcher eine erste Seite (6) des Schalters (2) mit einer zweiten Seite (7) des Schalters (2) wahlweise verbindet oder trennt, und zwei Erdungstrenner (10, 11) umfasst,
wobei jeder der beiden Erdungstrenner (10, 11) vorgesehen ist, um die erste Seite (6) oder die zweite Seite (7) wahlweise mit Erde (1) zu verbinden oder von Erde (1) zu trennen, und
wobei die Schaltanlage (30) ein System (9) nach einem der Ansprüche 9-12 umfasst.

## Claims

1. Method for testing a switching installation (30) for power transmission installations,
wherein the switching installation (30) comprises a switch (2) which selectively connects a first side (6) of the switch (2) to a second side (7) of the switch (2) or disconnects it therefrom, and comprises two earthing switches (10, 11),
wherein each of the two earthing switches (10, 11) is provided to selectively connect the first side (6) or the second side (7) to earth (1) or to disconnect it from earth (1),
wherein the method comprises:
- generating a current through the switch (2), and
- determining a magnitude of the current through the switch (2),
wherein the two earthing switches (10, 11) are closed during the generation and determination steps,
wherein, when the earthing switches (10, 11) are closed and the switch (2) is closed, the generated current flows partly through the earthing switches (10, 11) and the switch and partly through earth, and
wherein either the determining of the magnitude of the current through the switch (2) comprises measuring a current discharging into the earth (1) of the switching installation (30) and determining a total current which is composed of the current through the switch (2) and of the current discharging into the earth (1), or the current through the switch (2) is measured directly in order to determine the magnitude of the current through the switch (2).

2. Method according to claim 1,
**characterised in that**
the determining of the magnitude of the current through the switch (2) comprises fitting a split core of a current transformer in order to measure a further current by means of the current transformer and to determine the magnitude of the current through the switch (2) on the basis of the measured further current, or the magnitude of the current through the switch (2) is determined using a Rogowski coil.

3. Method according to any one of the preceding claims,
**characterised in that**
the method comprises fitting a split ferrite in order to increase the inductance of a current path to the earth (1) of the switching installation (30) to thereby force a greater proportion of the generated current through the switch (2).

4. Method according to any one of the preceding claims,
**characterised in that**
the current through the switch (2) is a direct current,
the determining of the magnitude of the current through the switch (2) comprises arranging a measuring device which operates by the Neel effect, in order to measure a further current and, on the basis thereof, to determine the current through the switch (2).

5. Method according to any one of the preceding claims,
**characterised in that**
a voltage which drops across the switch (2) is determined, and
a resistance of the switch (2) is determined on the basis of the magnitude of the current and the voltage which drops across the switch (2).

6. Method according to any one of the preceding claims,
**characterised in that**
the determining of the magnitude of the current through the switch (2) comprises detecting times of an abrupt change in the magnitude of the current in order to derive therefrom switching times of the switch (2).

7. Method according to any one of the preceding claims,
**characterised in that**
the switching installation (30) comprises a plurality of switches (2-4) which each selectively connect a first side (6) of the respective switch (2-4) to a second side (7) of the respective switch (2-4) or disconnect it therefrom, and are configured to switch a multiphase current,
associated with each side (6; 7) is a respective earthing switch (10; 11) to selectively connect the respective side (6; 7) to earth (1) or to disconnect it from earth (1), and
a magnitude of a current through each switch (2-4) is measured directly, or the magnitude of the current through each switch (2-4) is determined by measuring currents discharging into the earth (1) of the switching installation (30) and by determining a total current which is composed of the currents through the switches (2-4) and of the currents discharging into the earth (1).

8. Method according to any one of the preceding claims,
**characterised in that**
the switching installation (30) is a gas-insulated switching installation (30).

9. System for testing a switching installation (30) for energy transmission installations,
wherein the switching installation (30) comprises a switch (2) which selectively connects a first side (6) of the switch (2) to a second side (7) of the switch (2) or disconnects it therefrom, and comprises two earthing switches (10, 11),
wherein each of the two earthing switches (10, 11) is provided to selectively connect the first side (6) or the second side (7) to earth (1) or to disconnect it from earth (1),
wherein the system (9) comprises a first device (22) for generating a current, a second device (20) for measuring a measured variable of the switching installation (30), and control means (8),
wherein the system (9) is configured to generate a current through the switch (2) by means of the first device (22) when the earthing switches (10, 11) are closed, and to determine a magnitude of the current through the switch (2) by the control means (8) on the basis of the measured variable measured by the second device (20) without one of the two earthing switches (10, 11) being opened for this purpose,
wherein the system (9) is configured such that, when the earthing switches (10, 11) are closed and the switch (2) is closed, the generated current flows partly through the earthing switches (10, 11) and the switch and partly through earth, and
wherein the system (9) is configured either to determine the magnitude of the current through the switch (2) by measuring a current discharging into the earth (1) of the switching installation (30) and determining a total current which is composed of the current through the switch (2) and of the current discharging into the earth (1), or to measure directly the current through the switch (2) in order to determine the magnitude of the current through the switch (2).

10. System according to claim 9,
**characterised in that**
the second device (20) comprises an ammeter with a Rogowski coil.

11. System according to claim 10,
**characterised in that**
the system (9) is configured to detect current peaks, which occur when the switch (2) is switched on or off, by means of the Rogowski coil.

12. System according to any one of claims 9-11,
**characterised in that**,
the system (9) is configured to carry out the method according to any one of claims 1-8.

13. Switching installation for power transmission installations,
wherein the switching installation (30) comprises a switch (2), which selectively connects a first side (6) of the switch (2) to a second side (7) of the switch (2) or disconnects it therefrom, and two earthing switches (10, 11),
wherein each of the two earthing switches (10, 11) is provided to selectively connect the first side (6) or the second side (7) to earth (1) or to disconnect it from earth (1), and
wherein the switching installation (30) comprises a system (9) according to any one of claims 9-12.

## Revendications

1. Procédé de test d'une installation de distribution (30) destinée à des installations de transmission d'énergie,
dans lequel l'installation de distribution (30) comprend un interrupteur (2), lequel relie ou sépare sélectivement un premier côté (6) de l'interrupteur (2) à un second côté (7) de l'interrupteur (2), et deux séparateurs de terre (10, 11),
dans lequel chacun des deux séparateurs de terre (10, 11) est prévu pour relier sélectivement le premier côté (6) ou le second côté (7) à la terre (1) ou pour le séparer de la terre (1),
dans lequel le procédé comprend :
- la génération d'un courant à travers l'interrupteur (2), et
- la détermination d'une amplitude du courant à travers l'interrupteur (2),
dans lequel les deux séparateurs de terre (10, 11) sont fermés pendant les étapes de génération et de détermination,
dans lequel lorsque les séparateurs de terre (10, 11) sont fermés et que l'interrupteur (2) est fermé, le courant généré circule en partie par les séparateurs de terre (10, 11) et l'interrupteur et en partie par la masse, et
dans lequel soit la détermination de l'amplitude du courant à travers l'interrupteur (2) comprend la mesure d'un courant circulant dans la terre (1) de l'installation de distribution (30) et la détermination d'un courant total, lequel résulte du courant à travers l'interrupteur (2) et du courant circulant dans la masse (1), soit le courant à travers l'interrupteur (2) est mesuré directement afin de déterminer l'amplitude du courant à travers l'interrupteur (2).

2. Procédé selon la revendication 1,
**caractérisé en ce**
**que** la détermination de l'amplitude du courant à travers l'interrupteur (2) comprend le montage d'un noyau divisé d'un transformateur de courant afin de mesurer un courant supplémentaire au moyen du transformateur de courant et de déterminer l'amplitude du courant à travers l'interrupteur (2) en fonction du courant supplémentaire mesuré, ou que l'amplitude du courant à travers l'interrupteur (2) est déterminée à l'aide d'une bobine de Rogowski.

3. Procédé selon l'une des revendications précédentes,
**caractérisé en ce**
**que** le procédé comprend le montage d'une ferrite à clapet pour augmenter l'inductance d'un trajet de courant vers la terre (1) de l'installation de distribution (30) afin de forcer ainsi une plus grande proportion du courant généré à travers l'interrupteur (2).

4. Procédé selon l'une des revendications précédentes,
**caractérisé en ce**
**que** le courant à travers l'interrupteur (2) est un courant continu,
**que** la détermination de l'amplitude du courant à travers l'interrupteur (2) comprend la disposition d'un dispositif de mesure qui fonctionne avec l'effet Néel afin de mesurer un courant supplémentaire et, en fonction de celui-ci, de déterminer le courant à travers l'interrupteur (2).

5. Procédé selon l'une des revendications précédentes,
**caractérisé en ce**
**qu'**une tension chutant aux bornes de l'interrupteur (2) est déterminée, et
**qu'**une résistance de l'interrupteur (2) est déterminée en fonction de l'amplitude du courant et de la tension chutant aux bornes de l'interrupteur (2).

6. Procédé selon l'une des revendications précédentes,
**caractérisé en ce**
**que** la détermination de l'amplitude du courant à travers l'interrupteur (2) comprend une détection d'instants d'un changement brusque de l'amplitude du courant afin d'en déduire des instants de distribution de l'interrupteur (2).

7. Procédé selon l'une des revendications précédentes,
**caractérisé en ce**
**que** l'installation de distribution (30) comprend une pluralité d'interrupteurs (2-4) qui relient ou séparent respectivement sélectivement un premier côté (6) de l'interrupteur (2-4) respectif à un second côté (7) de l'interrupteur (2-4) respectif et qui sont destinés à commuter un courant polyphasé,
**qu'**un séparateur de terre (10; 11) est associé respectivement à chaque côté (6; 7) pour relier sélectivement le côté (6; 7) respectif à la terre (1) ou pour le séparer de la terre (1),
et
**qu'**une amplitude d'un courant à travers chaque interrupteur (2-4) est mesurée directement ou que l'amplitude du courant à travers chaque interrupteur (2-4) est déterminée en mesurant les courants circulant dans la terre (1) de l'installation de distribution (30) et en déterminant un courant total, lequel est composé des courants à travers les interrupteurs (2-4) et des courants circulant dans la terre (1).

8. Procédé selon l'une des revendications précédentes,
**caractérisé en ce**
**que** l'installation de distribution est une installation de distribution à isolation gazeuse (30).

9. Système de test d'une installation de distribution (30) destinée à des installations de transmission d'énergie,
dans lequel l'installation de distribution (30) comprend un interrupteur (2), lequel relie ou sépare sélectivement un premier côté (6) de l'interrupteur (2) à un second côté (7) de l'interrupteur (2), et deux séparateurs de terre (10, 11),
dans lequel chacun des deux séparateurs de terre (10, 11) est prévu pour relier sélectivement le premier côté (6) ou le second côté (7) à la terre (1) ou pour le séparer de la terre (1),
dans lequel le système (9) comprend un premier dispositif (22) permettant de générer un courant, un second dispositif (20) permettant de mesurer une grandeur de mesure de l'installation de distribution (30) et des moyens de commande (8),
dans lequel le système (9) est conçu, lorsque les séparateurs de terre (10, 11) sont fermés, pour générer un courant à travers l'interrupteur (2) au moyen du premier dispositif (22) et pour déterminer, au moyen des moyens de commande (8), une amplitude du courant à travers l'interrupteur (2) à l'aide de la grandeur de mesure mesurée au moyen du second dispositif (20), sans ouvrir l'un des deux séparateurs de terre (10, 11) à cet effet,
dans lequel le système (9) est conçu de telle manière que lorsque les séparateurs de terre (10, 11) sont fermés et que l'interrupteur (2) est fermé, le courant généré circule en partie par le séparateur de terre (10, 11) et l'interrupteur et en partie par la masse, et dans lequel le système (9) est conçu pour soit déterminer l'amplitude du courant à travers l'interrupteur (2) en mesurant un courant circulant dans la terre (1) de l'installation de distribution (30) et un courant total résultant du courant à travers l'interrupteur (2) et du courant circulant dans la masse (1), soit pour mesurer directement le courant à travers l'interrupteur (2) afin de déterminer l'amplitude du courant à travers l'interrupteur (2).

10. Système selon la revendication 9,
**caractérisé en ce**
**que** le second dispositif (20) comprend un ampèremètre comportant une bobine de Rogowski.

11. Système selon la revendication 10,
**caractérisé en ce**
**que** le système (9) est conçu pour détecter des pointes de courant, lesquelles se produisent lorsque l'interrupteur (2) est allumé ou éteint, au moyen de la bobine de Rogowski.

12. Système selon l'une des revendications 9 à 11,
**caractérisé en ce**
**que** le système (9) est conçu pour exécuter le procédé selon l'une des revendications 1 à 8.

13. Installation de distribution destinée aux installations de transmission d'énergie,
dans lequel l'installation de distribution (30) comprend un interrupteur (2), lequel relie ou sépare sélectivement un premier côté (6) de l'interrupteur (2) à un second côté (7) de l'interrupteur (2), et deux séparateurs de terre (10, 11),
dans lequel chacun des deux séparateurs de terre (10, 11) est prévu pour relier sélectivement le premier côté (6) ou le second côté (7) à la terre (1) ou pour le séparer de la terre (1), et
dans lequel l'installation de distribution (30) comprend un système (9) selon l'une des revendications 9 à 12.
